Europäisches Patentamt

European Patent Office

Office européen des brevets

(19)

(11) EP 0 296 838 B1

(12) EUROPEAN PATENT SPECIFICATION

(45) Date of publication and mention
of the grant of the patent:
**27.03.1996  Bulletin 1996/13**

(51) Int Cl.6: **H03B 9/14**

(21) Application number: **88305708.5**

(22) Date of filing: **22.06.1988**

(54) **Monolithic microwave transmitter/receiver**

Monolithischer Mikrowellen-Sender/Empfänger

Emetteur-récepteur micro-ondes monolythique

(84) Designated Contracting States:
**DE FR GB NL**

(30) Priority: **26.06.1987 US 67527**
**05.08.1987 US 82027**

(43) Date of publication of application:
**28.12.1988  Bulletin 1988/52**

(73) Proprietor: **TEXAS INSTRUMENTS
INCORPORATED
Dallas Texas 75265 (US)**

(72) Inventors:
• **Bayraktaroglu, Burhan
Plano Texas 75075 (US)**
• **Camilleri, Natalino
Dallas Texas 75229 (US)**

(74) Representative: **Abbott, David John et al
Abel & Imray
Northumberland House
303-306 High Holborn
London, WC1V 7LH (GB)**

(56) References cited:
**US-A- 3 778 717**

• MICROWAVE JOURNAL, vol. 30, no. 3, March
1987, pages 109-110,114,116-117, Norwood,
MA, US; T.O. PERKINS III: "Active microstrip
circular patch antenna"
• PATENT ABSTRACTS OF JAPAN, vol. 5, no.
153 (E-76)[825], 26th September 1981 & JP-A-56
85 907
• IEEE TRANSACTIONS ON MICROWAVE
THEORY AND TECHNIQUES, vol. MTT-33, no.
12, December 1985, pages 1603-1610, IEEE,
New York, US; S.J. NIGHTINGALE et al.: "A
30-GHz monolithic single balanced mixer with
integrated dipole receiving element"

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

BACKGROUND OF THE INVENTION

### 1. Field of the Invention.

The present invention relates to electronic semiconductor devices, and, more particularly, to monolithic microwave and millimeter wave devices and systems.

### 2. Description of the Related Art.

Microwave and millimeter wave transmitters are usually designed around discrete components. A transmitter requires a power source (free-running or controlled oscillator) and a radiating element (antenna); however, the technologies typically used to fabricate the oscillator and the antenna are incompatible. Thus hybrid transmitters with the oscillator and the antenna on separate substrates is standard. Monolithic millimeter wave oscillators often use IMPATT diodes with the frequency of oscillation determined by circuit impedance and specific diode conditions or by injection-locking signals; and the oscillator power is typically coupled out by a microstrip transmission line and fed into a microstrip patch or waveguide antenna. See for example R.Dinger et al, A 10 GHz Space Power Combiner with Parasitic Injection Locking, 1986 IEEE MTT Symposium Digest 163 and K.Carver et al, Microstrip Antenna Technology, 29 IEEE Tr.Ant.Prop 2 (1981). For a transmitter operating over a band of frequencies, the antenna and the oscillator are designed for close impedance match throughout the bandwidth of operation to minimize mismatch losses.

However, the known transmitters have the problems of mismatch losses, design difficulties, and hybrid fabrication cost and difficulties.

Further, a hybrid transmitter precludes the possibility of monolithic integration of the transmitter with other devices such as mixers, detectors, capacitors, and transistors.

Complex microwave and millimeter wave circuits are increasingly being monolithically integrated on single chips with microstrip transmission line interconnections. However, many circuits and systems require waveguide components (e.g., low-loss filters) and waveguide remains one of the best transmission lines. Many high performance systems are still contructed using waveguide components, and most measurement insturmentation is built around waveguide transmission lines. Thus various methods for making waveguide-microstrip transitions have appeared. For example, J.Van Heuven, A New Integrated Waveguide-Microstrip Transition, 24 IEEE Tr.Mic.Th.Tech. 144 (1976); C.Verner et al, Quarter-Wave Matching of Waveguide-to-Finline Transitions, 32 IEEE Tr.Mic.Th.Tech. 1645 (1984); and R. Neidert, Waveguide-to-Coax-to-Microstrip Transitions for Millimeter-Wave Monolithic Circuits, Microwave Journal 93 (June 1983). These and other transitions such as E-probe and ridge-type all hvve limited bandwidth and transition losses.

Monolithic microwave and millimeter wave oscillators often use IMPATT diodes with the frequency of oscillation determined by circuit impedance and specific diode conditions or by injection-locking signals; and the oscillator power is typically coupled out by a microstrip transmission line and fed into a microstrip patch or waveguide antenna. See for example R.Dinger et al, A 10 GHz Space Power Combiner with Parasitic Injection Locking, 1986 IEEE MTT Symposium Digest 163 and K.Carver et al, Microstrip Antenna Technology, 29 IEEE Tr.Ant.Prop. 2 (1981). For a transmitter operating over a band of frequencies, the antenna and the oscillator are designed for close impedance match throughout the bandwidth of operation to minimize mismatch losses.

However, the known monolithic transmitters (and receivers) have the problems of mismatch losses and waveguide-to-microstrip transition bandwidth limitations and losses.

The Microwave Journal, vol. 30, no 3, March 1987, pages 109-110, 114, and 116-117, discloses a microwave transmitter comprising a circular microstrip patch serving as both an antenna and a resonator, and an IMPATT diode shunt connected between the patch and the ground plane; the transmitter is formed on a RT/duroid 5880 substrate having a relative dielectric constant of 2.2.

US-A 3 778 717 discloses a microwave transmitter comprising a rectangular microstrip patch serving both as a resonator and by means of a slot in the patch as an antenna. A Gunn diode is connected between the microstrip patch and a copper substrate acting as the ground plane. The insulator between the patch and the ground plane is a styrene copolymer.

The IEEE Transactions on Microwave Theory and Techniques, vol MTT-33, no. 12, December 1985, pages 1603-1610, discloses a microwave mixer formed on a gallium arsenide substrate and comprising Shottky barrier or Mott diodes. Signals from a local oscillator port and an intermediate frequency port are carried to the diodes along an alumina substrate and then along microstrip and coplanar strip lines on the gallium arsenide substrate. The mixed signal is carried along coplanar strips to a bow tie shaped dipole antenna also formed on the surface of the substrate.

## SUMMARY OF THE INVENTION

The present invention provides a microwave or millimetre wave transmitter or receiver including an oscillator comprising,

an active device, and
a microstrip patch functioning, in use, simultaneously as a resonator and as an antenna,
characterised in that the active device and the microstrip patch are formed on the same semiconductor substrate.

The present invention also provides a method of fabrication of a monolithic transmitter, comprising the steps of:

providing a layered semiconductor substrate having a first surface;
etching said layered semiconductor substrate to form vertical diodes on plural mesas on said first surface of said substrate;
forming a microstrip patch on said surface between two of said mesas; and
forming air bridges from said diodes on said two mesas to said patch.

The monolithic microwave or millimeter wave transmitter/receiver of the present invention has its power source, its impedance matching circuits, and the radiating element on a single semiconductor chip by combining an oscillator circuit with an antenna so that the properties of these two elements match automatically. Because the oscillator and the antenna are an integrated unit, there are no mismatch losses. Further, in preferred embodiments the oscillator is a free-running IMPATT diode fabricated on a semi-insulating gallium arsenide (GaAs) substrate with a half-wavelength microstrip patch antenna also fabricated on the semi-insulating GaAs substrate; the antenna acts as a resonator for the oscillator with the dimensions of the patch determining both the frequency of oscillation and the frequency of radiation for automatic matching. The diodes perform the local oscillator and mixer functions for signals received by the antenna. Other active devices such as mixer diodes, transistors and passive circuit elements such as capacitors, resistors, inductors, directional couplers and transmissions lines may also be integrated on the same semi-insulating GaAs substrate to form monolithic systems useful in microwave/millimeter wave radars and communication systems.

The use of an antenna also as a resonator for an oscillator solves the problems of mismatch of the oscillator with the antenna and permits integration of the antenna and oscillator on a single substrate.

Further, in one embodiment the present invention also provides a monolithic microwave or millimeter wave transmitter/receiver mounted on a waveguide end ground plane with an oscillator circuit and microstrip patch antenna on a single substrate and radiating into the waveguide. Because the oscillator and the antenna are an integrated unit, there are no mismatch losses, and the radiation pattern from the antenna approximately matches the radiation pattern from the end of a waveguide transmission line so the coupling of energy from the transmitter to the waveguide is good.

In preferred embodiments the oscillator is a free-running IMPATT diode fabricated on a semi-insulating gallium arsenide (GaAs) substrate with a half-wavelength microstrip patch antenna also fabricated on the semi-insulating GaAs substrate; the antenna acts as a resonator for the oscillator with the dimensions of the patch determining both the frequency of oscillation and the frequency of radiation for automatic matching. The antenna is oriented in the waveguide to have the radiation $\vec{E}$ and $\vec{H}$ fields parallel to those of the waveguide. The diodes perform the local oscillator and mixer functions for signals received by the antenna. Other active devices such as mixer diodes, transistors and passive circuit elements such as capacitors, resistors, inductors, directional couplers and transmissions lines may also be integrated on the same semi-insulating GaAs substrate to form monolithic systems useful in microwave/millimeter wave radars and communication systems.

The use of an antenna also as a resonator for an oscillator and mounted on the end of a waveguide solves the problems of mismatch of the oscillator with the antenna and avoids the microstrip to waveguide transition problems.

## BRIEF DESCRIPTION OF THE DRAWINGS

The drawings are schematic for clarity.

FIGS.1A-B are plan and cross sectional elevation views of a first preferred embodiment;
FIG.2 is a cross sectional elevation view illustrating the electric and magnetic fields in the first preferred embodiment;
FIG.3 is a schematic equivalent circuit for the first preferred embodiment;
FIGS.4A-F are cross sectional elevation views of a first preferred embodiment method of fabrication of the first preferred embodiment;
FIGS.5A-B are plan and cross sectional elevation views of a second preferred embodiment;
FIG.6 is a plan view of a third preferred embodiment; and

FIG.7 is a plan view of a fourth preferred embodiment.
FIGS.8A-B are exploded perspective and cross sectional elevation views of a fifth preferred embodiment;
FIG.9 is a perspective view of the third preferred embodiment mounted in a waveguide; and
FIG.10 is a plan view of the fourth preferred embodiment mounted in a waveguide.

## DESCRIPTION OF THE PREFERRED EMBODIMENTS

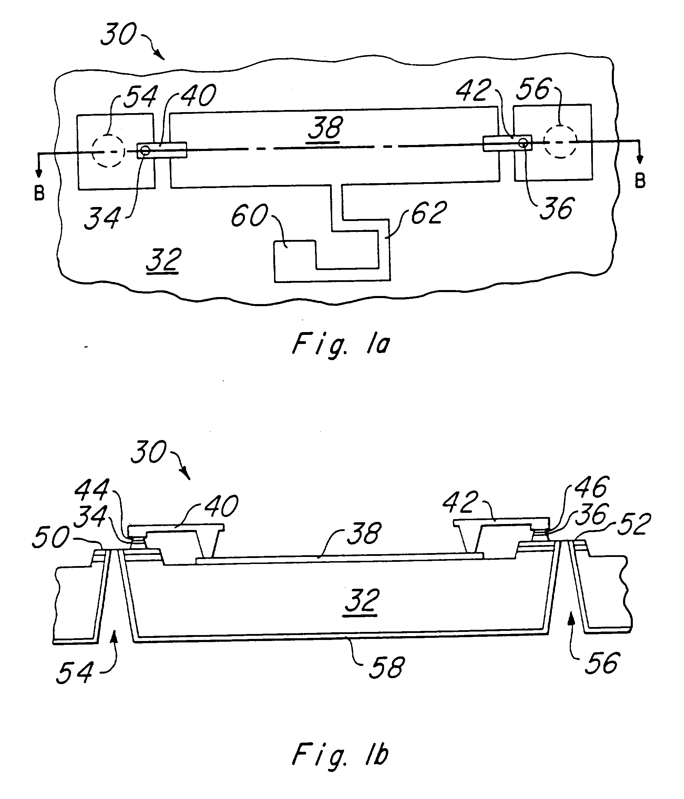

Figures 1A-B are plan and cross sectional elevation views of a first preferred embodiment transmitter, generally denoted with the reference numeral 30, which includes semi-insulating gallium arsenide (GaAs) substrate 32, IMPATT diodes 34 and 36, half-wavelength microstrip patch 38, air bridges 40 and 42 connecting diodes 34 and 36 to patch 38, respectively, metal top contacts 44 and 46 for diodes 34 and 36, respectively, metal bottom contacts 50 and 52 for diodes 34 and 36, respectively, metallized vias 54 and 56 connecting backside ground plane 58 to bottom contacts 50 and 52, respectively, and diode bias pad 60 connected to the middle of patch 38 by quarter-wavelength long high impedance microstrip line 62. For operation about 50 GHz, patch 38 is about 1 mm long (horizontal direction in Figures 1A-B) by about 125 $\mu$m wide by 2 $\mu$m thick, substrate 32 is 125 $\mu$m thick, diodes 34 and 36 are each 5 $\mu$m in diameter and 1.2 $\mu$m high, and air bridges 40 and 42 are about 20 $\mu$m long and 5 $\mu$m wide, so the horizontal separation of patch 38 from the diodes 34 and 36 is about 10 $\mu$m. Patch 38 together with ground plane 58 form the antenna as a cavity that radiates. The direct current to bias diodes 34 and 36 into breakdown is supplied at pad 60; note that the dominant mode in the antenna has an electric field null in the middle where line 62 connects to patch 38, so minimal power loss occurs due to the bias arrangement.

Analysis of a general rectangular microstrip patch antenna may be made using a modal-expansion cavity model if the substrate is electrically thin; see the K.Carver et al reference cited in the Background. The operation of transmitter 30 may be explained by first applying this general analysis that views patch 38 over ground plane 58 as a thin TM-mode cavity with magnetic sidewalls. Substrate 32 is electrically thin (125 $\mu$m thick with a dielectric constant of 12.9) compared to the length of patch 38, so the electric field between patch 38 and ground plane 58 will be approximated as $z$-directed if $x$ and $y$ are the coordinates in the plane of patch 38. Thus the interior modes will be TM$_{mn}$ to $z$ so that

$$\vec{E} = \sum_{m,n} c_{m,n} \vec{e}_{m,n}(x,y)$$

where $C_{m,n}$ are the mode amplitudes and $\vec{e}_{m,n}(x,y)$ are the $z$-directed orthonormalized electric field mode vectors. If the cavity is nonradiating with open-circuit sidewalls, then

$$\vec{e}_{0,0}(x,y) = \vec{k} \frac{1}{\sqrt{\varepsilon abt}}$$

$$\vec{e}_{m,0}(x,y) = \vec{k} \frac{\sqrt{2}}{\sqrt{\varepsilon abt}} \cos(m\pi y/b) \qquad m \neq 0$$

$$\vec{e}_{0,n}(x,y) = \vec{k} \frac{\sqrt{2}}{\sqrt{\varepsilon abt}} \cos(n\pi x/a) \qquad n \neq 0$$

$$\vec{e}_{m,n}(x,y) = \vec{k} \frac{\sqrt{2}}{\sqrt{\varepsilon abt}} \cos(n\pi x/a)\cos(m\pi y/b) \qquad m,n \neq 0$$

with $x$ and $y$ coordinate axes along the edges of patch 38, $a$ the width of patch 38, $b$ the length of patch 38, $t$ the thickness of substrate 32, and $\varepsilon$ the dielectric constant. The corresponding magnetic field orthonormalized mode vectors, $\vec{h}_{m,n}(x,y)$, are proportional to

$$i(m\pi/b) \cos(n\pi x/a) \sin(m\pi y/b) + j(n\pi/a) \sin(n\pi x/a) \cos(m\pi y/b)$$

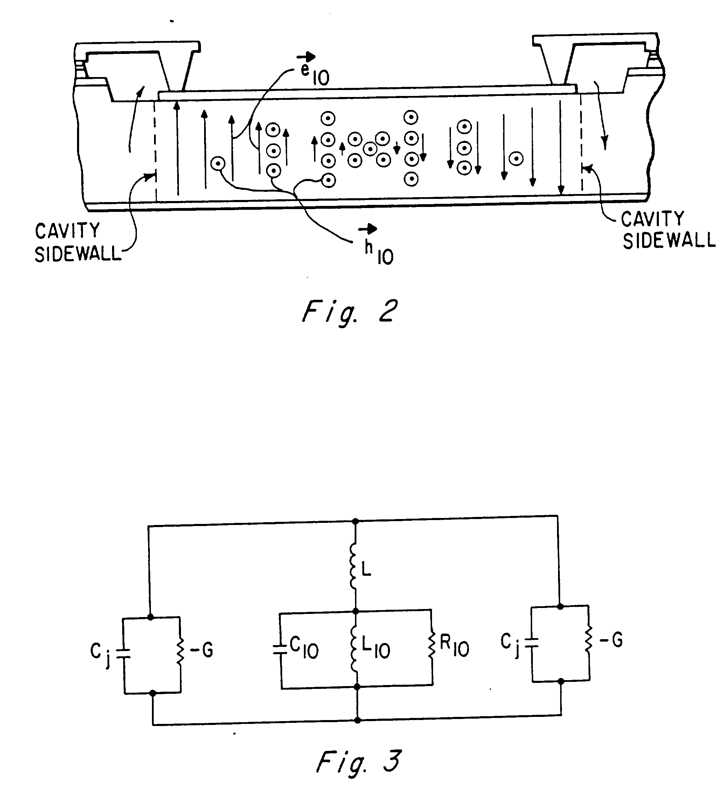

so $\vec{h}_{m,n}$ is normal to the cavity sidewalls as required for no radiation. Figure 2 schematically illustrates the electric and magnetic fields for the TM$_{10}$ mode along the same cross section as Figure 1B; the cavity sidewalls are indicated by dashed lines.

As the cavity is allowed to radiate, the mode wave numbers become complex, $\vec{h}_{m,n}$ develops a tangential component on the cavity sidewalls, but the electric field mode vectors are still accurately approximated by the $\vec{e}_{m,n}$ with the complex wave numbers $k_n$ and $k_m$ replacing $n\pi/a$ and $m\pi/b$. I$k_n$I is slightly less than $n\pi/a$ and I$k_m$I is slightly less than $m\pi/b$; thus the TM$_{10}$ mode radiates with a wavelength slightly greater than $2b\sqrt{\varepsilon}$. When the loading of diodes 34 and 36 is included, the wavelength further slightly increases.

The input impedance for the radiating cavity can be approximated by considering a current probe at one of air bridges 40 and 42 and computing the series expansion coefficients for $\vec{E}$ with approximate electric mode vectors. The result (see the Carver et al article) is a sum over $m \geq 0$ and $n \geq 0$; the (0,0) term is the static capacitance with a shunt resistance to represent loss in substrate 32, the (1,0) term represents the dominant microwave mode and has spatial variation approximated by the nonradiating $\vec{e}_{1,0}$ (which varies as $\cos(\pi y/b)$ along the length of patch 38 and is constant across the width), and the higher order modes have negligible losses and sum to form a net inductance L. The (1,0) mode term is equivalent to a parallel R-L-C network where R represents radiation, substrate, and conductor losses. Figure 3 is a schematic equivalent circuit for transmitter 30 over a narrow band about an isolated $TM_{10}$ mode in which the antenna has been replaced by this input impedance (labelled with subscripts 10 for the R-L-C of the (1,0) mode) and each of the diodes 34 and 36 has been replaced by an equivalent negative conductance -G plus a junction capacitance $C_j$ The resonant frequency occurs when the inductances and capacitances cancel and $R_{10} - 2G = 0$; that is, the power generated by diodes 34 and 36 is absorbed by $R_{10}$ which is primarily the radiation resistance (i.e., it is radiated).

The design of transmitter 30, given the substrate material and thickness and a desired frequency, $f$, generally follows the steps of (1) selecting the length $b$ of patch 38 as half of the desired wavelength multiplied by a length reduction factor $q$ to account for fringing fields and the loading by diodes 34 and 36:

$$b = q\frac{c}{2f\sqrt{\varepsilon}},$$

(2) selecting the width $a$ of patch 38 by computing an approximate cavity sidewall impedance as a function of $a$ and adjusting $a$ so that this impedance matches the free space impedance of 377 $\Omega$, and (3) computing the Q of the cavity; if the Q is too low the resonator effect is poor and if the Q is too high the antenna is not efficient. To change the Q requires revising the original substrate thickness data provided that the same substrate material and frequency of operation are still desired. If the substrate thickness is adjusted, the $b$ and $a$ are recomputed.

In practice, computer simulations such as SUPERCOMPACT for a variety of $a$ and $b$ values compute oscillation frequency and antenna efficiency and, in effect, design the transmitter. Note that if the frequency is very high (100 GHz) the permitted effective thickness of the substrate is limited by the rule of thumb of demanding that the second harmonic is still a TM mode and not a surface mode. A thin substrate implies small $a$. Although a substrate with a smaller dielectric constant (such as Teflon with constant about 2.4) and lower loss tangent that GaAs would be preferable from a pure antenna point of view, GaAs is a compromise that permits monolithic integration of the diodes and antenna plus other devices.

The far-field radiation pattern in the $TM_{10}$ mode can be modelled as two parallel uniform magnetic line sources of length $a$ (corresponding to the short ends of patch 38) separated by distance $b$ (the length of patch 38).

Further characteristics of transmitter 30 may be understood from a consideration of a first preferred embodiment method of fabrication which includes the following steps:

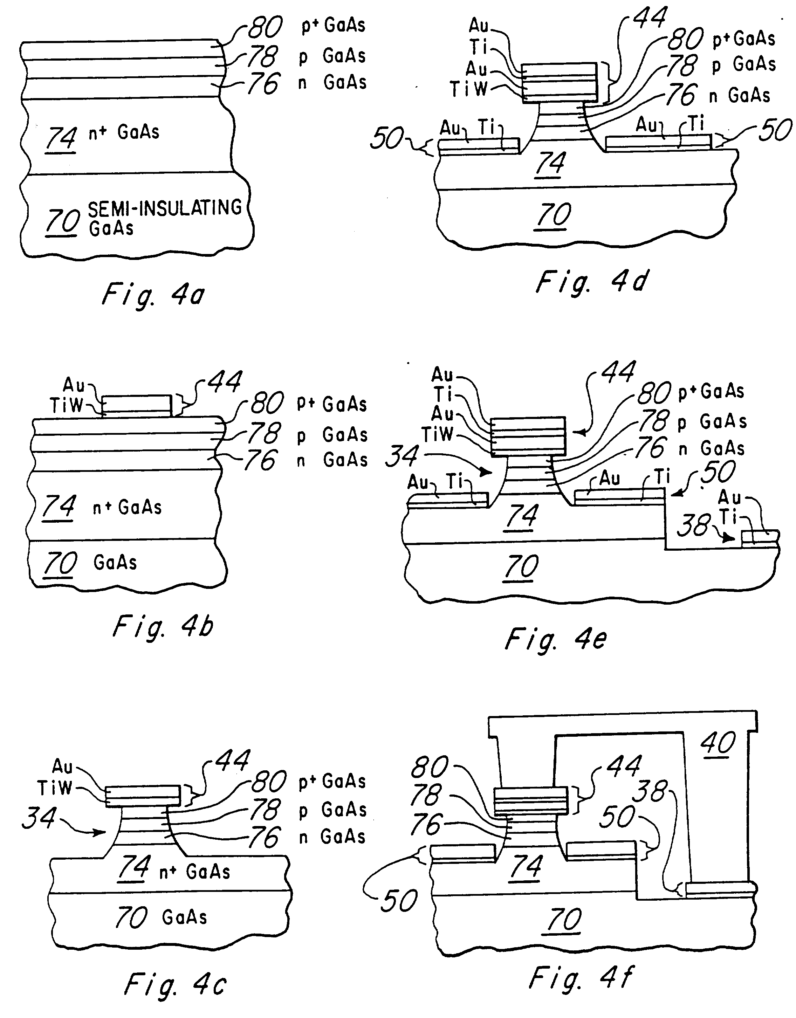

(a) Grow a single crystal semiconductor multilayer structure 66 by molecular beam epitaxy (MBE), metal organic chemical vapor deposition (MOCVD), or similar techniques beginning with gallium arsenide (GaAs) substrate 70 and adding successive layers with composition, thickness, and doping level as set forth in the following table; see Figure 4A for a cross sectional view.

| Layer | Composition | Thickness | Doping ($cm^{-3}$) |
|---|---|---|---|
| 70 | GaAs | large | undoped |
| 74 | $n^+$ GaAs | 1.5 $\mu$m | $1 \times 10^{19}$ |
| 76 | $n$ GaAs | 0.25 $\mu$m | $2 \times 10^{17}$ |
| 78 | $p$ GaAs | 0.25 $\mu$m | $2 \times 10^{17}$ |
| 80 | $p^+$ GaAs | 0.2 $\mu$m | $1 \times 10^{19}$ |

Note that MBE and MOCVD with *in situ* doping provides very sharp junctions between the drift layers 78 and 80; this avoids the fall off of negative conductance at high frequencies associated with a doping transition region at the junction. GaAs substrate 70 is semi-insulating.

(b) Form diode top contacts 44 and 46 by spinning on photoresist and patterning it to define contacts 44 and 46 as circles 5 $\mu$m in diameter, sputtering 0.1 $\mu$m of TiW (an alloy of about 10% titanium and 90 % tungsten) and 0.4 $\mu$m of gold, and etching off around the patterned photoresist so as to leave contacts 44 and 46. See Figure 4B which only shows contact 44. The gold is primarily to prevent oxidization of the TiW, and the TiW chosen for its good adherence to and low metallurgical reaction with GaAs.

(c) Etch layers 80, 78, 76, and 74 with contact 44 as the etch mask by a timed wet etching to stop in layer 74; this forms diodes 34 and 36 with a base diameter of 5 $\mu$m. The etchant may be a solution of hydrogen peroxide with five percent ammonium hydroxide, and the large thickness of layer 74 allows for ease of stopping the etch in layer 74. The isotropic nature of this etch leads to an overhang by contact 44; see Figure 4C and note that the vertical scale is exaggerated for clarity so the characteristic circular isotropically etched surface under the overhang appears pyramidal.

(d) Form diode bottom contacts 50 and 52 by spinning on photoresist and patterning it to define contacts 50 and 52 as squares with 75 μm edges, evaporating 0.1 μm of titanium and 0.4 μm of gold, and lifting off the patterned photoresist and the metal on it. Diode top contacts 44 and 46 act as masks during the evaporation and lead to self-aligned bottom contacts 50 and 52 due to the overhangs; see Figure 4D. Top contacts 44 and 46 are both increased in thickness by the evaporations, and the self-aligned nature of bottom contacts 50 and 52 minimizes parasitic series resistance.

(e) Anisotropically plasma etch layer 74 and 0.1 μm of substrate 70 using the metal contacts 44, 46, 50, and 52 as etch mask. This isolates the diodes on mesas on semi-insulating substrate 70. Form microstrip patch 38 on substrate 70 again by evaporation and liftoff of a 0.1 μm thick layer of titanium followed by a 0.4 μm thick layer of gold. See Figure 4E which shows the just diode 34 and a small portion of patch 38.

(f) Form air bridges 40 and 42 by spinning on photoresist, patterning openings to contacts 44 and 46, evaporating thin layers of titanium and gold, spinning on further photoresist, patterning the same openings plus the bridging connections between the openings, and plating gold to a thickness of 2.0 μm on the exposed gold. Remove the photoresist which also liftoff the thin titanium and gold between the two layers of photoresist. See Figure 4F.

(g) Lap substrate 70 down to a thickness of 125 μm to form substrate 32. Form vias 54 and 56 in the backside of substrate 32 by photoresist masking and reactive ion etching, the etch stops on bottom contacts 50 and 52. Lastly, gold plate the backside, including vias 54 and 56 to form ground plane 58.

Other devices may also be integrated on substrate 70 just prior to formation of patch 38 in step (e). In particular, active device regions may be implanted in the semi-insulating substrate 70 away from diodes 34 and 36 and the area for patch 38. Alternatively, additional photolithographic masking may be used in the etching of layer 74 step (e) to preserve regions of $n^+$ doped GaAs for device fabrication.

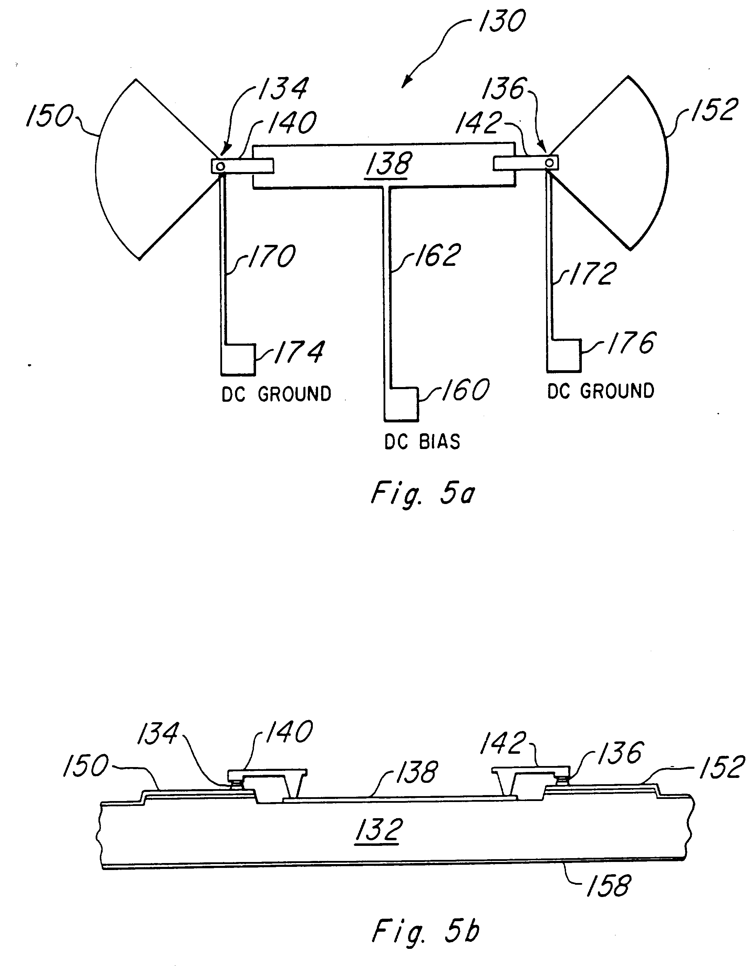

Second preferred embodiment transmitter 130 is illustrated in plan and cross sectional elevation views in Figures 5A-B. Transmitter 130 is similar to transmitter 30 and two IMPATT diodes 134 and 136 at either end of microstrip patch 138 which acts as both an antenna and a resonator. The via grounding of the diodes in transmitter 30 has been replaced by separate grounding of the dc and rf impedances of the diodes: the bottom diode contacts 150 and 152 are shaped into radial stubs to produce an effective rf short circuit impedance at the diode terminal, and two dc return paths 170 and 172 of halfwavelength long high impedance transmission line lead to dc grounded pads 174 and 176. DC bias is from pad 160 through halfwavelength high impedance transmission line 162 to the center of patch 138; air bridges 140 and 142 connect diodes 134 and 136 to patch 138. Radial stubs 150 and 152 should have properties matching those of resonator 138 in the frequency range of operation; however, this is easily achieved because radial stubs generally operate over a broad band of frequencies. The backside of substrate 132 is gold-plated ground plane 158.

The preferred embodiments also function as receivers. The diodes provide the local oscillator (LO) and mixer functions, whereas the resonator/antenna is used for receiving and modifying the impedance of incoming signals for optimum reception sensitivity. The low frequency mixed signal is taken out along the dc bias line. Further, the embodiments may operate in a pulsed transmit/receive mode as follows: first the diodes are biased for power generates at a frequency $f_1$ and a pulse is transmitted at this frequency, then the diode bias is changed (which changes the diode small signal conductance and susceptance) to change the resonant frequency to $f_2$. The antenna then receives a signal arising from the reflection of the transmitted pulse at $f_1$ which is mixed by the diodes (which are nonlinear) with $f_2$ to create the output signal.

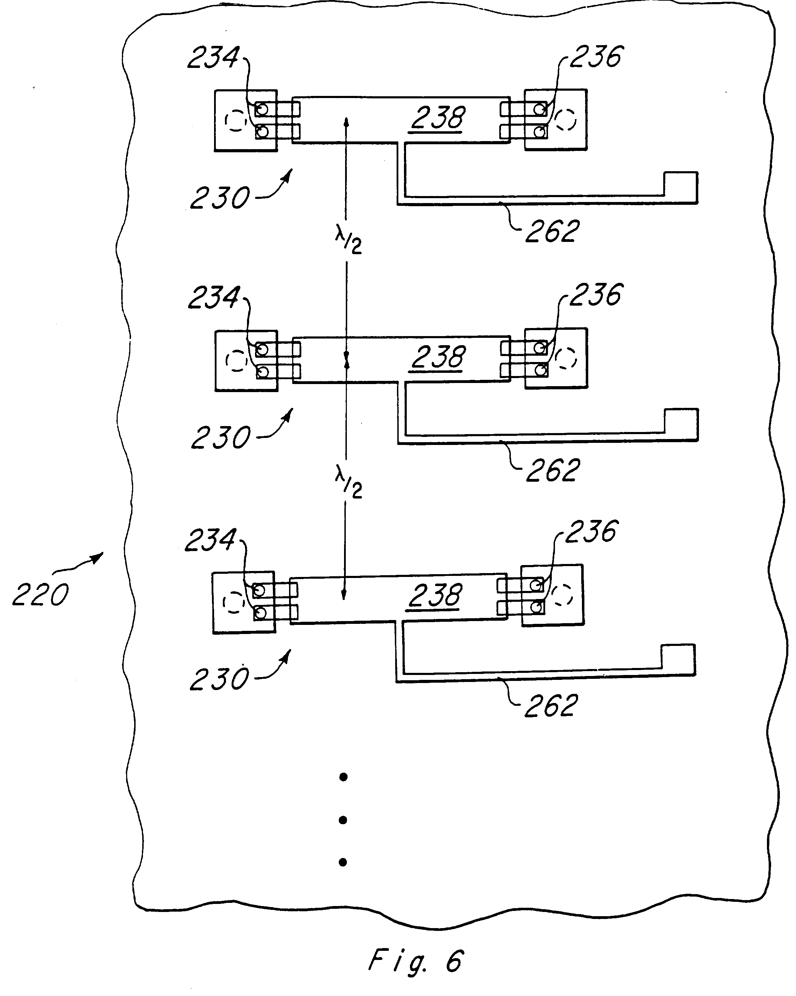

A third preferred embodiment transmitter 220 is illustrated in plan view in Figure 6 and combines a number of identical monolithic transmitters 230. Each transmitter 230 is similar to transmitter 30 but with two diodes 234, 236 at each end of its microstrip patch 238 and with an independent dc bias line 262 for each transmitter; transmitters 230 are in a linear array on a single semiconductor surface. By placing the patches 238 on a center-to-center distance of about $\frac{1}{2}\lambda$, where $\lambda$ is the tree space wavelength, the radiated beam is perpendicular to the semiconductor surface. The phasing of the individual transmitters 230 is achieved by coupling through the fringing fields; this provides spatial power combining and coherent power. Because each transmitter 230 has its own biasing capability, relative strength of radiation from each transmitter 230 can be controlled independently for convenient beam steering and shaping.

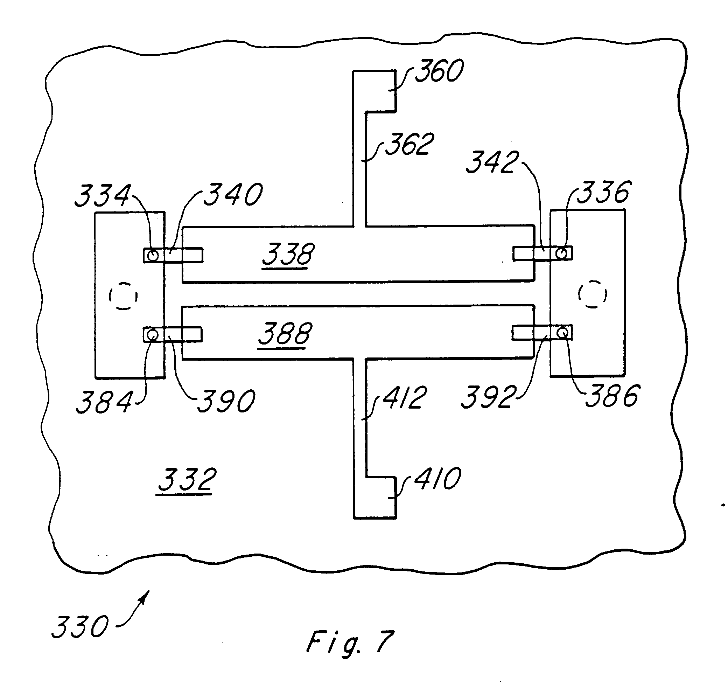

Fourth preferred embodiment transmitter 330 is illustrated in plan view in Figure 7 and is similar to two transmitters 30 with one acting as a transmitter and the other acting as a varactor to permit control of the frequency of oscillation. Transmitter 330 includes IMPATT diodes 334 and 336, microstrip patch resonator/antenna 338, air bridges 340 and 342 connecting diodes 334 and 336 to patch 338, high impedance dc bias line 362, dc bias supply pad 360, varactor diodes 384 and 386 connected by air bridges 390 and 392 to microstrip patch 388, high impedance dc bias line 412, dc bias supply pad 410. During operation of transmitter 330 diodes 334 and 336 are biased into breakdown and provide power to resonator/antenna 338; whereas diodes 384 and 386 are biased below breakdown with their junction capacitance dependent upon the bias voltage and providing variable capacitive loading for patch 338 through the coupling of patch 388 with patch 338. Thus the bias applied at pad 410 determines the frequency of oscillation, typically with a range of about 30% about the center frequency. Patches 338 and 388 are separated by no more than about $\frac{1}{16}\lambda$ for strong coupling.

Transmitter 330 also performs as a receiver in the manner of the other preferred embodiments previously described, but transmitter 330 also has the capability of modulating the frequency for FMCW radar transmitting and receiving.

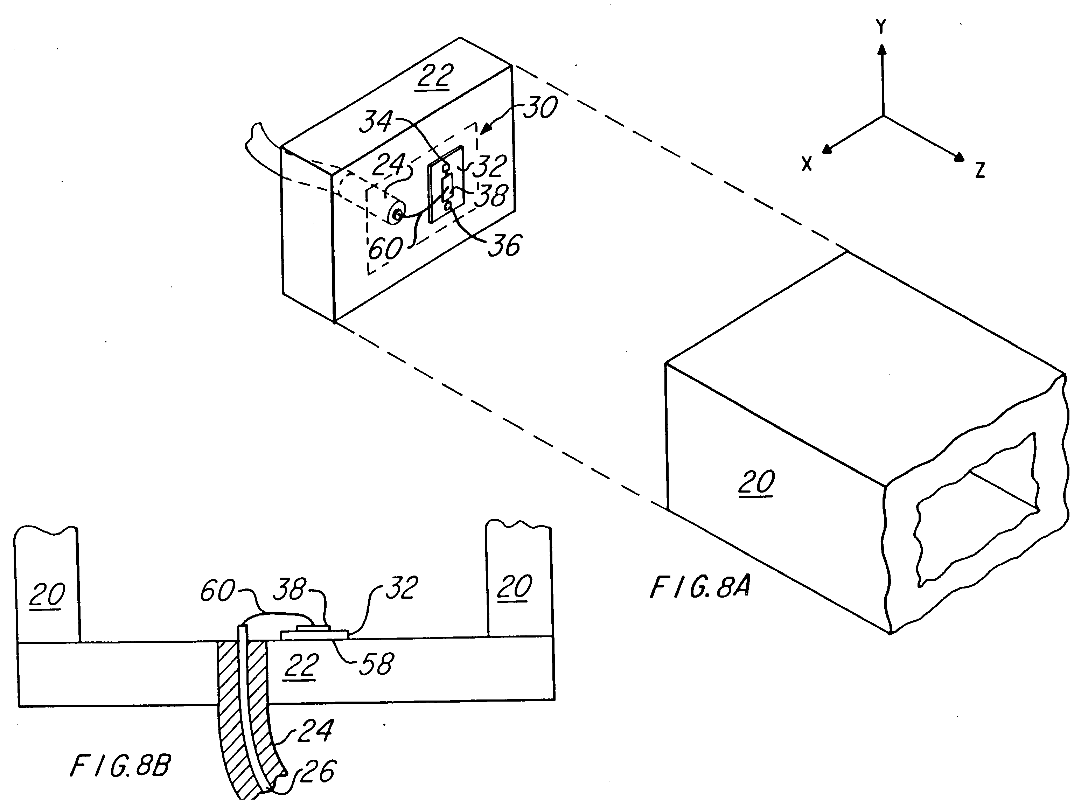

Figures 8A-B are exploded perspective and cross sectional elevation views of the fifth preferred embodiment transmitter/receiver including waveguide 20 with end plate 22, semiconductor chip 30 with microstrip patch antenna 38 and IMPATT diodes 34 and 36 on gallium arsenide substrate 32, diode dc bias wire 60, and coaxial transmission line 24 with center conductor 26 passing through end plate 22. The backside of chip 30 has a ground plane which contacts end plate 22. Waveguide 20 and end plate 22 are made of brass, and chip 30 (which has a plated gold backside ground plane) is attached to end plate 22 by soldering and wire 60 is bonded to coaxial center conductor 26 and to patch 38. Wire 60 is gold of 25 μm diameter and 200 μm length, and coaxial transmission line 24 is 0.58 mm outer diameter made of copper with teflon insulator and a 0.13 mm diameter center conductor 26 made of silver-plated copper-clad steel. Center conductor 26 extends about 0.2 mm beyond the surface of end plate 22. The dimensions of waveguide 20 depend upon the desired frequency of operation. Chip 30 is the same as the first preferred embodiment 30 illustrated in Figures 1A-B and thus has the same reference numeral.

Waveguide 20 would have inside dimensions of about 2.84 mm high by 5.69 mm wide for operation in the 33-50 GHz band. Note that the wavelength in chip 30 is much smaller than in waveguide 20 because the dielectric constant of GaAs is about 13 times that of the air in waveguide 20.

The far-field radiation pattern for the cavity in the $TM_{10}$ mode can be modelled as two parallel uniform magnetic line sources of length $a$ (corresponding to the short ends of patch 38) separated by distance $b$ (the length of patch 38); see the Carver article. The approximation about the $z$ axis yields an electric field in the $y$ direction. This corresponds to a $TE_{01}$ mode in waveguide 20, and the radiation from the cavity couples to this mode in waveguide 20 propagating in the $z$ direction. Thus wire 60 is parallel to the magnetic field in waveguide 20 and is transparent to the waveguide circuit which causes minimal interaction. As described *infra*, chip 30 may also be used as a receiver and mixer for waves propagating in the negative $z$ direction, and the intermediate frequency mixed signal is extracted by wire 60 and coaxial transmission line 24. The characteristic impedance of coaxial transmission line 24 is conveniently low (e.g., 5 Ω) for receiver/mixer use.

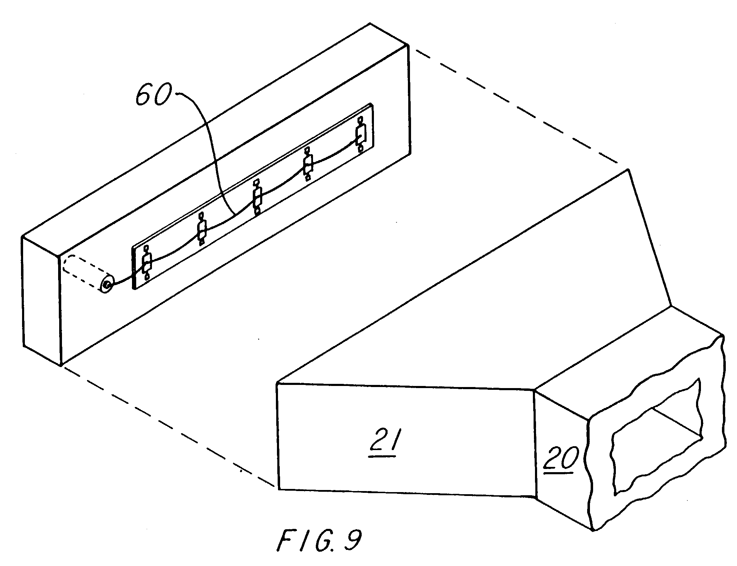

The third preferred embodiment 220 may also be mounted in a waveguide as shown in Figure 9; the width of chip 220 (compared to chip 30) may require a tapered section 21 of waveguide 20 as shown in Figure 9.

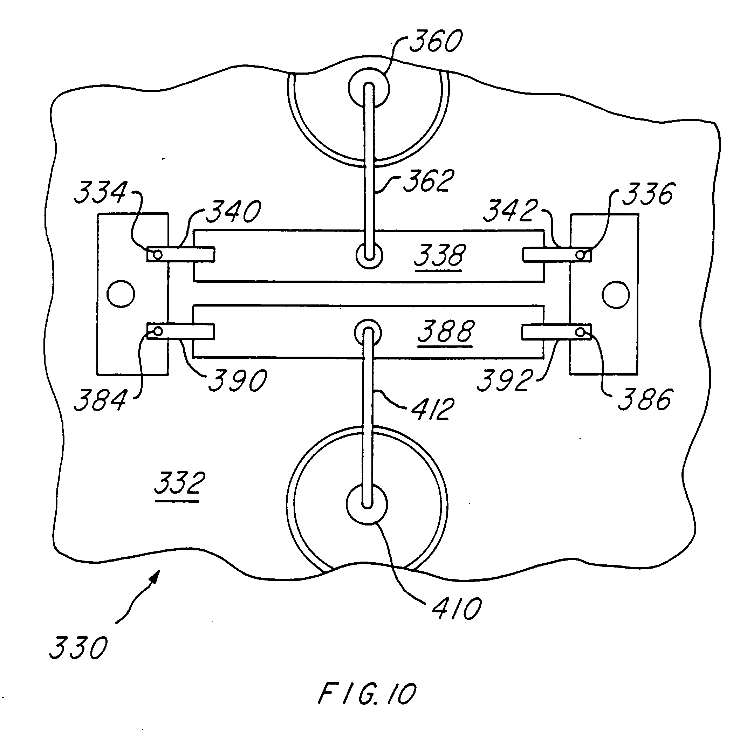

Fourth preferred embodiment 330 may also be mounted in waveguide in a manner analogous to the first preferred embodiment as illustrated in Figure 10; two coaxial center conductors 1360 and 1410 are used together with wires 1362 and 1412.

MODIFICATIONS AND ADVANTAGES

Various modifications of the preferred embodiment devices and methods may be made while retaining the features of an antenna that is also the oscillator resonator or of a planar transmitter circuit in which the power generating device is on the same surface of semiconductor as the radiating element while maintaining strong dc and rf grounding of one of the device terminals or of mounting in a waveguide.

For example, the dimensions and shapes and materials of the various elements may be varied such as: circular or other geometry microstrip patches; only a single diode connected to the resonator/antenna if the capacitance of the diode is small compared to the capacitance of the resonator to retain approximate symmetry; multiple diodes connected to either or both ends of the resonator/antenna; GaAs-on-silicon, InP, $Al_xGa_{1-x}As$ heterostructure or other semiconductor material; other power devices including BARITT, TRAPATT, and DOVETT diodes, Gunn diodes, tunnel diodes or three terminal devices with negative resistance regions, or other monolithic active devices for oscillator power; and monolithic coupled arrays of oscillators/antennas.

The invention provides the advantage of use of the oscillator resonator as the antenna to avoid mismatch losses and permit monolithic integration.

**Claims**

1. A microwave or millimetre wave transmitter or receiver (30,130,230,330) including an oscillator comprising,

an active device (34,36,134,136,234,236,334,336), and
a microstrip patch (38,138,238,338) functioning, in use, simultaneously as a resonator and as an antenna,

characterised in that the active device and the microstrip patch are formed on the same semiconductor substrate (32,332).

2. A transmitter or receiver as claimed in claim 1, wherein the substrate (32,332) is gallium arsenide with a metallized ground plane (58,158) on the backside.

3. A transmitter or receiver as claimed in claim 1 or claim 2, wherein the active device is a plurality of IMPATT diodes (34,36,134,136,234,236,334,336) and there are provided means for biassing the diodes into breakdown.

4. A transmitter or receiver as claimed in claim 3, wherein the diodes are formed on mesas on the substrate (32,332).

5. A transmitter or receiver as claimed in claim 3 or claim 4 wherein the diodes (34,36,134,136,234,236,334, 336) are connected to the microstrip patch by air bridges (40).

6. A transmitter or receiver as claimed in claim 3, or claim 4, or claim 5, when dependent on claim 2, wherein the diodes are connected to the ground plane through vias (54,56) in the substrate.

7. A transmitter or receiver as claimed in any one of claims 3 to 5, wherein the diodes (34,36,134,136,234,236, 334,336) are connected to ground through radial stubs (150,152)and dc bias lines (170,174).

8. A transmitter or receiver as claimed in any preceding claim, wherein the oscillator includes a further microstrip (388) patch adjacent the said microstrip patch (38,138,238,338) and a varactor (384,386) connected to the further patch (388) and loading the first said patch (38,138,238,338).

9. A transmitter or receiver as claimed in claim 8 wherein the varactor (384,386) is a diode and that diode is connected to the further microstrip patch (388) by an air bridge (390,392).

10. A transmitter or receiver as claimed in any preceding claim comprising, a low frequency line (24) connected to the first said microstrip patch (38,138,238,338), whereby signals received by said antenna are mixed by said active device to a low frequency.

11. An array microwave transmitter (220), comprising a plurality of transmitters as claimed in any preceding claim on a semiconductor substrate.

12. A method of fabrication of a monolithic transmitter, comprising the steps of: providing a layered semiconductor substrate (32,332) having a first surface; etching said layered semiconductor substrate to form vertical diodes (34,36,134,136,234,236,334,336) on plural mesas on said first surface of said substrate; forming a microstrip patch (38,138,238,338) on said surface between two of said mesas; and forming air bridges (40) from said diodes on said two mesas to said patch.

13. A method as claimed in claim 12, wherein the diodes (34,36,134,136,234,236,334,336) are IMPATT diodes.

14. A method as claimed in claim 12 or claim 13, wherein the mesas are formed of gallium arsenide.

15. A method as claimed in any one of claims 12 to 14, further including the step of forming bottom contacts (50,52) to said diodes disposed on said surface.

16. A method as claimed in claim 15, further including the steps of forming vias (54,56) through said substrate and forming conductors in said vias extending to said bottom contacts (50,52).

17. A method as claimed in claim 15 or claim 16, wherein said bottom contacts (50,52) are self aligned.

**Patentansprüche**

1. Mikrowellen- oder Millimeterwellen-Sender oder -Empfänger (30, 130, 230, 330) mit einem Oszillator, enthaltend:

eine aktive Vorrichtung (34, 36, 134, 136, 234, 236, 334, 336), und

einen Mikrostreifen-Flächenbereich (38, 138, 238, 338), der im Betrieb gleichzeitig als Resonator und Antenne wirkt,

dadurch gekennzeichnet, daß die aktive Vorrichtung und der Mikrostreifen-Flächenbereich auf dem gleichen Halbleitersubstrat (32, 332) gebildet sind.

2. Sender oder Empfänger nach Anspruch 1, bei welchem das Substrat (32, 332) aus Galliumarsenid mit einer metallisierten Masseebene (58, 158) auf der Rückseite besteht.

3. Sender oder Empfänger nach Anspruch 1 oder Anspruch 2, bei welchem die aktive Vorrichtung aus mehreren IMPATT-Dioden (34, 36, 134, 136, 234, 236, 334, 336) besteht und daß Mittel zum Vorspannen der Dioden in den Durchbruchzustand vorgesehen sind.

4. Sender oder Empfänger nach Anspruch 3, bei welchem die Dioden auf Mesas auf dem Substrat (32, 332) gebildet sind.

5. Sender oder Empfänger nach Anspruch 3 oder Anspruch 4, bei welchem die Dioden (34, 36, 134, 136, 234, 236, 334, 336) an den Mikrostreifen-Flächenbereich über Luftbrücken (40) angeschlossen sind.

6. Sender oder Empfänger nach Anspruch 3, Anspruch 4 oder Anspruch 5, bei Rückbeziehung auf Anspruch 2, bei welchem die Dioden über Durchkontaktierungslöcher (54, 56) im Substrat mit der Masseebene verbunden sind.

7. Sender oder Empfänger nach einem der Ansprüche 3 bis 5, bei welchem die Dioden (34, 36, 134, 136, 234, 236, 334, 336) über radiale Stichleitungen (150, 152) und Gleichspannungs-Vorspannungsleitungen (170, 172) mit Masse verbunden sind.

8. Sender oder Empfänger nach einem der vorhergehenden Ansprüche, bei welchem der Oszillator einen weiteren Mikrostreifen-Flächenbereich (388) angrenzend an den Mikrostreifen-Flächenbereich (38, 138, 238, 338) und einen Varaktor (384, 386) enthält, der mit dem weiteren Flächenbereich (388) verbunden ist und den ersten Flächenbereich (38, 138, 238, 338) belastet.

9. Sender oder Empfänger nach Anspruch 8, bei welchem der Varaktor (384, 386) eine Diode ist und diese Diode über eine Luftbrücke (390, 392) mit dem weiteren Mikrostreifen-Flächenbereich (388) verbunden ist.

10. Sender oder Empfänger nach einem der vorhergehenden Ansprüche, enthaltend eine Niederfrequenzleitung (24), die an den ersten Mikrostreifen-Flächenbereich (38, 138, 238, 338) angeschlossen ist, wodurch von der Antenne empfangene Signale durch die aktive Vorrichtung auf eine niedrige Frequenz gemischt werden.

11. Matrix-Mikrowellensender (220) mit mehreren Sendern gemäß einem der vorhergehenden Ansprüche auf einem Halbleitersubstrat.

12. Verfahren zum Herstellen eines monolithischen Senders, enthaltend die Schritte:

Herstellen eines geschichteten Halbleitersubstrats (32, 332) mit einer ersten Fläche;

Ätzen des geschichteten Halbleitersubstrats zur Bildung vertikaler Dioden (34, 36, 134, 136, 234, 236, 334, 336) auf mehreren Mesas auf der ersten Fläche des Substrats;

Bilden eines Mikrostreifen-Flächenbereichs (38, 138, 238, 338) auf der Fläche zwischen zwei Mesas; und

Bilden von Luftbrücken (40) von den Dioden auf den zwei Mesas zu dem Flächenbereich.

13. Verfahren nach Anspruch 12, bei welchem die Dioden (34, 36, 134, 136, 234, 236, 334, 336) IMPATT-Dioden sind.

14. Verfahren nach Anspruch 12 oder Anspruch 13, bei welchem die Mesas aus Galliumarsenid gebildet sind.

15. Verfahren nach einem der Ansprüche 12 bis 14, ferner enthaltend den Schritt des Bildens von Bodenkontakten (50, 52) zu den Dioden, die auf der Fläche angeordnet sind.

**16.** Verfahren nach Anspruch 15, ferner enthaltend die Schritte des Bildens von Durchkontaktierungslöchern (54, 56) durch das Substrat und des Bildens von Leitern in den Durchkontaktierungslöchern, die sich zu den Bodenkontakten (50, 52) erstrecken.

**17.** Verfahren nach Anspruch 15 oder Anspruch 16, bei welchem die Bodenkontakte (50, 52) selbstjustiert sind.

**Revendications**

**1.** Emetteur ou récepteur de micro-ondes ou d'ondes millimétriques (30, 130, 230, 330) comprenant un oscillateur comportant,

un dispositif actif (34, 36, 134, 136, 234, 236, 334, 336), et
un connecteur à microlame (38, 138, 238, 338) fonctionnant, en utilisation, simultanément comme un résonateur et comme une antenne, caractérisé en ce que le dispositif actif et le connecteur à microlame sont formés sur le même substrat semi-conducteur (32, 332).

**2.** Emetteur ou récepteur selon la revendication 1, dans lequel le substrat (32, 332) est de l'arséniure de gallium avec une plaque de mise à la masse métallisée (58, 158) sur le côté postérieur.

**3.** Emetteur ou récepteur selon l'une des revendications 1 et 2, dans lequel le dispositif actif est constitué d'une pluralité de diodes IMPATT (34, 36, 134, 136, 234, 236, 334, 336) et dans lequel sont prévus des moyens pour polariser les diodes au niveau de leur tension de claquage.

**4.** Emetteur ou récepteur selon la revendication 3, dans lequel les diodes sont formées sur des mesas sur le substrat (32, 332).

**5.** Emetteur ou récepteur selon l'une des revendications 3 et 4, dans lequel les diodes (34, 36, 134, 136, 234, 236, 334, 336) sont reliées au connecteur à microlame par des ponts à air (40).

**6.** Emetteur ou récepteur selon l'une des revendications 3 et 4, ou selon la revendication 5 dépendante de la revendication 2, dans lequel les diodes sont reliées à la plaque de mise à la masse par des trous métallisés (54, 56) dans le substrat.

**7.** Emetteur ou récepteur selon l'une quelconque des revendications 3 à 5, dans lequel les diodes (34, 36, 134, 136, 234, 236, 334, 336) sont reliées à la masse par des adaptateurs à lignes radiaux (150, 152) et des lignes de polarisation à courant continu (170, 174).

**8.** Emetteur ou récepteur selon l'une quelconque des revendications précédentes, dans lequel l'oscillateur comporte en outre un connecteur à microlame additionnel (388) adjacent audit connecteur à microlame (38, 138, 238, 338) et un varactor (384, 386) relié au connecteur additionnel (388) et chargeant ledit premier connecteur (38, 138, 238, 338).

**9.** Emetteur ou récepteur selon la revendication 8 dans lequel le varactor (384, 386) est une diode et en ce que la diode est reliée au connecteur à microbande additionnel (388) par un pont à air (390, 392).

**10.** Emetteur ou récepteur selon l'une quelconque des revendications précédentes comprenant,
une ligne à basse fréquence (24) reliée audit premier connecteur à microlame (38, 138, 238, 338) de telle sorte que des signaux reçus par ladite antenne sont , mélangés par ledit dispositif actif à une basse fréquence.

**11.** Réseau d'émetteurs de micro-ondes (220), comprenant une pluralité d'émetteurs selon l'une quelconque des revendications précédentes, sur un substrat semi-conducteur.

**12.** Procédé pour fabriquer un émetteur à semi-conducteur, comprenant les étapes consistant à :

fournir un substrat semi-conducteur à couches (32, 332) comportant une première surface,
attaquer ledit substrat semi-conducteur à couches pour former des diodes verticales (34, 36, 134, 136, 234, 236, 334, 336) sur une pluralité de mesas sur ladite première surface sur ledit substrat ;

former un connecteur à microlame (38, 138, 238, 338) sur ladite surface entre deux desdits mesas ; et former des ponts à air (40) à partir desdites diodes sur lesdits deux mesas dudit connecteur.

13. Procédé selon la revendication 12, dans lequel les diodes (34, 36, 134, 136, 234, 236, 334, 336) sont des diodes IMPATT.

14. Procédé selon l'une des revendications 12 et 13, dans lequel les mesas sont formés d'arséniure de gallium.

15. Procédé selon l'une quelconque des revendications 12 à 14, comportant de plus l'étape consistant à former des contacts inférieurs (50, 52) pour lesdites diodes disposées sur ladite surface.

16. Procédé selon la revendication 15, comportant de plus les étapes consistant à former des trous métallisés (54, 56) à travers ledit substrat et à former des conducteurs dans lesdits trous s'étendant jusqu'audits contact inférieur (50, 52).

17. Procédé selon l'une des revendications 15 et 16, dans lequel lesdits contacts inférieurs (50, 52) sont, alignés d'eux-mêmes.

*Fig. Ia*

*Fig. Ib*

Fig. 2

Fig. 3

*Fig. 4a*

*Fig. 4b*

*Fig. 4c*

*Fig. 4d*

*Fig. 4e*

*Fig. 4f*

*130*

*134*

*140*

*136*

*142*

*150*

*152*

*138*

*170*

*162*

*172*

*174*

*176*

DC GROUND

DC GROUND

*160*

DC BIAS

Fig. 5a

*134*

*140*

*142*

*136*

*150*

*138*

*152*

*132*

*158*

Fig. 5b

*Fig. 6*

Fig. 7

FIG.8A

FIG.8B

EP 0 296 838 B1

FIG.9

FIG. 10